# EUROPÄISCHE PATENTSCHRIFT

(11) **EP 1 979 291 B1**
(45) Veröffentlichungstag und Bekanntmachung des Hinweises auf die Patenterteilung: **01.08.2012**
(21) Anmeldenummer: 07726198.0
(22) Anmeldetag: 16.01.2007
(51) Int. Cl.: C04B 35/626, C04B 35/495, H01L 41/24, H01L 41/187

(54) **BLEIFREIER PIEZOKERAMISCHER WERKSTOFF, VERFAHREN ZUM HERSTELLEN EINES PIEZOKERAMISCHEN BAUTEILS MIT DEM WERKSTOFF UND VERWENDUNG DES BAUTEILS**
LEAD-FREE PIEZOCERAMIC MATERIAL, METHOD FOR THE PRODUCTION OF A PIEZOCERAMIC COMPONENT BY MEANS OF SAID MATERIAL, AND USE OF THE COMPONENT
MATÉRIAU CÉRAMIQUE PIÉZOÉLECTRIQUE SANS PLOMB, PROCÉDÉ DE PRODUCTION D'UN COMPOSANT CÉRAMIQUE PIÉZOÉLECTRIQUE DOTÉ DE CE MATÉRIAU ET UTILISATION DU COMPOSANT AINSI OBTENU

(30) Priorität: 31.01.2006 DE 102006004447
(43) Veröffentlichungstag der Anmeldung: 15.10.2008
(73) Patentinhaber: SIEMENS AKTIENGESELLSCHAFT, 80333 München (DE)
(72) Erfinder: CARDIN, Aurelie, Nl-2594 CL's Den Haag (NL); WESSLER, Berit, 93049 Regensburg (DE)
(86) Internationale Anmeldenummer: PCT/EP2007/050404
(87) Internationale Veröffentlichungsnummer: WO 2007/101737

(56) Entgegenhaltungen:
- EP-A- 1 702 906
- WO-A-2006/030940
- JP-A- 2002 293 628
- JP-A- 2002 338 355
- JP-A- 2003 277 145
- JP-A- 2003 300 776
- JP-A- 2003 327 472
- JP-A- 2004 075 448
- JP-A- 2005 179 144

## Beschreibung

Die Erfindung betrifft einen bleifreien piezokeramischen Werkstoff, ein Verfahren zum Herstellen eines piezokeramischen Bauteils mit dem Werkstoff und eine Verwendung des Bauteils.

Bleihaltige piezokeramische Werkstoffe auf der Basis des binären Mischsystems von Bleizirkonat und Bleititanat, so genanntes Bleizirkonattitanat (Pb(Ti, Zr)O₃, PZT), werden derzeit wegen ihrer exzellenten mechanischen und piezoelektrischen Eigenschaften, beispielsweise hohe Curietemperatur T_{c} von über 300° C oder hoher d₃₃-Koeffizient im Groß- und Kleinsignalbereich, in vielen Bereichen der Technik eingesetzt. Piezokeramische Bauteile mit diesen Werkstoffen sind beispielsweise Biegewandler, Vielschichtaktoren und Ultraschallwandler. Diese Bauteile werden in der Aktorik, der Medizintechnik, der Ultraschalltechnik oder der Automobiltechnik eingesetzt.

Im Hinblick auf eine verbesserte Umweltverträglichkeit sollen zukünftig bleifreie piezokeramische Werkstoffe zum Einsatz kommen. Aus Y. Saito et al., Lead-free piezoceramics, Nature, 11, (2004), vol. 432, Seiten 84 bis 87 ist beispielsweise ein bleifreier, phasenreiner piezokeramischer Werkstoff mit guten piezoelektrischen Eigenschaften bekannt. Der Werkstoff besteht aus einer Perowskit-Phase auf der Basis eines Kalium-Natrium-Niobats(KNN). Die Summenformel des piezokeramischen Werkstoffs lautet (Li_{0,04}K_{0,44}Na_{0,52}) (Nb_{0,86}Ta_{0,1}Sb_{0,04})O₃. Die Curietemperatur beträgt 253° C. Der d₃₃-Koeffizient beträgt im Großsignalbereich etwa 300 pm/V (Polung bei 5 kV/mm).

Aus der EP 1 702 906 A1 ist ein bleifreier piezokeramischer Werkstoff folgender Zusammensetzung bekannt: (1-m-n){(Na_{1-x-y} KₓLi_{y}) (Nb_{1-z}Ta_{z}) O₃} + m{(M1) ZrO₃} + n{M2) Nb_{1-w}Ta_{w})₂O₆}, wobei M1 und M2 Erdalkalimetalle sind und folgende Zusammenhänge gelten: 0,1 ≤ x ≤ 0,9; 0 ≤ y ≤ 0,1; 0 < m < 0,1; 0 < n ≤ 0,01.

Aus der JP 2005 179144 A ist ein bleifreier piezokeramischer Werkstoff folgender Zusammensetzung bekannt: (1-m-n){(Na_{1-x-y-} KₓLi_{y}) (Nb_{1-z}Ta_{z})O₃} + m{(M1)TiO₃} + n{M2)Nb_{1-w}Ta_{w})₂O₆}, wobei M1 und M2 Erdalkalimetalle sind und folgende Zusammenhänge gelten: 0,1 ≤ x ≤ 0,9; 0 ≤ y ≤ 0,1; 0 < m < 0,1; 0 < n ≤ 0,01. Dabei können zusätzliche Dotierungen aus der Gruppe Co, Fe, Ni, Zn, Sc Ti, Zr, Hf, Al, Ga, In, Si und Sn vorhanden sein.

Aus der JP 2003 300776 A ist ein bleifreier piezokeramischer Werkstoff folgender Zusammensetzung bekannt: Mlₘ(Nb_{1-z}Ta_{z})O₃. Dabei ist M1 ein Alkalimetall.

Aufgabe der Erfindung ist es, eine Alternative zum bekannten, bleifreien piezokeramischen Werkstoff anzugeben, der ähnlich gute piezoelektrische Eigenschaften aufweist.

Zur Lösung der Aufgabe wird ein piezokeramischer Werkstoff angegeben, aufweisend mindestens eine Perowskit-Phase mit der Summenformel Ap (Nb_{1-w-z}Ta_{w}Sb_{z}) O₃, wobei Ap mindestens ein Alkalimetall der Perowskit-Phase ist und folgende Zusammenhänge gelten: 0 ≤ w ≤ 0,15 und 0 ≤ z ≤ 0,15, und mindestens eine Wolframbronze-Phase mit der Summenformel Aw₅(Nb₁₋ᵥTaᵥ)₅O₁₅, wobei Aw mindestens ein Alkalimetall der Wolframbronze-Phase ist und folgender Zusammenhang gilt: 0 ≤ v ≤ 1.

Der piezokeramische Werkstoff beinhaltet ein bleifreies, zumindest zweiphasiges System, das eine Perowskit-Phase auf Basis eines Alkali-Niobats und eine Wolframbronze-Phase auf Basis eines Alkali-Niobats oder auf Basis eines Alkali-Tantalats aufweist. Das Alkali-Niobat der Perowskit-Phase ist mit Tantal und/oder mit Antimon dotiert. Vorzugsweise ist zumindest eines dieser Metalle vorhanden sind (w + z ≠ 0). Für die Wolframbronze-Phase sind neben den reinen Alkali-Niobaten bzw. Alkali-Tantalaten insbesondere Mischformen dieser beiden oxidischen Alkali-Verbindungen denkbar. Die Mischform enthält sowohl Niob als auch Tantal (Alkali-Niobat-Tantalat). Es hat sich überraschenderweise gezeigt, dass der piezokeramische Werkstoff dann sehr gute piezoelektrische Eigenschaften zeigt, wenn er, nicht wie es aus dem Stand der Technik bekannt ist, einphasig (phasenrein), sondern zwei- oder mehrphasig ist. Dabei ist neben mindestens einer Perowskit-Phase mindestens eine Wolframbronze-Phase vorhanden. Darüber hinaus können weitere (feste) Phasen vorhanden sein.

Sowohl die Perowskit-Phase als auch die Wolframbronze-Phase weisen ein Alkalimetall oder mehrere Alkalimetalle auf. Die beiden Phasen können das gleiche Alkalimetall bzw. die gleichen Alkalimetalle aufweisen. Dankbar ist auch, dass die Alkalimetalle der beiden Phasen unterschiedlich sind. Dies bedeutet, dass Ap und Aw ungleich sind.

In einer besonderen Ausgestaltung lautet die Summenformel der Perowskit-Phase (LiₓK_{1-x-y}Na_{y}) (Nb_{1-w-z}Ta_{w}Sb_{z}) O₃. Dabei gelten folgende Zusammenhänge: 0 ≤ x ≤ 0,15 und 0,25 ≤ y ≤ 0,75. Die Perowskit-Phase basiert auf dem Kalium-Natrium-Niobat-System. Neben Kalium und Natrium kann als weiteres Alkalimetall Ap der Perowskit-Phase Lithium vorhanden sein.

Die Wolframbronze-Phase des piezokeramischen Werkstoffs weist bevorzugt folgende Summenformel auf: Li₂(K₁₋ᵤNaᵤ)₃(Nb₁₋ᵥTaᵥ)₅O₁₅. Dabei gilt folgender Zusammenhang: 0 ≤ u ≤ 1. Als Alkalimetall Aw der Wolframbronze-Phase ist in jedem Fall Lithium vorhanden. Wahlweise sind neben dem Lithium Kalium und/oder Natrium als Alkalimetall Aw der Wolframbronze-Phase enthalten. In einer bevorzugten Ausgestaltung gelten folgende Zusammenhänge: u = 0, v = 1 und x = 0. Die Summenformel der Wolframbronze-Phase lautet demnach: Li₂K₃Ta₅O₁₅. Die Wolframbronze-Phase ist ein Lithium-Kalium-Tantalat. Besonders gute piezoelektr'ische Eigenschaften lassen sich durch die Kombination des genannten Lithium-Kalium-Tantalats mit der Perowskit-Phase folgender Zusammensetzung erzielen: (K_{1-y}Na_{y}) (Nb_{1-z}Sb_{z})O₃. Die Perowskit-Phase ist ein Kalium-Natrium-Niobat mit Antimon. In der aufgezeigten Kombination sind die Alkalimetalle Ap der Perowskit-Phase und die Alkalimetalle Aw der Wolframbronze-Phase unterschiedlich.

Die Anteile der beiden Phasen können sehr unterschiedlich sein. Im Hinblick auf gute piezoelektrische Eigenschaften ist es besonders vorteilhaft, wenn ein Wolframbronze-Anteil der Wolframbronze-Phase am Feststoff des piezokeramischen Werkstoffs aus dem Bereich von einschließlich 0,01 Vol.% bis einschließlich 25,0 Vol.% und insbesondere aus dem Bereich von einschließlich 0,05 Vol.% bis einschließlich 15,0 Vol.% ausgewählt ist. Vorzugweise ist der Wolframbronzeanteil bis einschließlich 10 Vol.% gewählt. Bei einem Werkstoff, der nur aus den beiden angegebenen Phasen besteht, ergibt sich für einen Perowskit-Anteil der Perowskit-Phase am Feststoff des piezokeramischen Werkstoffs ein Wert aus dem Bereich von einschließlich 99,99 Vol.% bis einschließlich 75,0 Vol.% und insbesondere ein Wert aus dem Bereich von.einschließlich 99,95 Vol.% bis einschließlich 85 Vol.% bzw. 90 Vol.% Wesentlich an den guten piezoelektrischen Phasen ist die Kombination dieser beiden Phasen. Neben den beiden Phasen können aber auch weitere, feste Phasen vorhanden sein.

Sowohl die Perowskit-Phase als auch die Wolframbronze-Phase können weitere Dotierstoffe aufweisen. Diese weiteren Dotierstoffe sind beispielsweise Seltenerdmetalle. Als Seltenerdmetall kann dabei ein beliebiges Element der Lanthaniden- oder Actiniden-Gruppe eingesetzt werden, beispielsweise Europium, Gadolinium, Lanthan, Neodym, Praseodym und Samarium. Vorzugsweise sind diese weiteren Dotierstoffe Erdalkalimetalle.

In einer besonderen Ausgestaltung beträgt ein molarer Bleianteil an der piezokeramischen Zusammensetzung unter 0,1 mol% und insbesondere unter 0,01 mol%. Dies bedeutet, dass die Wolframbronze-Phase und die Piezokeramik-Phase im Wesentlichen keine Bleiionen enthalten. Dies gilt auch für eventuell weitere, im piezokeramischen Werkstoff enthaltene Phasen. Trotz des Fehlens der Bleiionen, vor allem trotz des Fehlens der Bleiionen in der Perowskit-Phase, werden sehr gute piezoelektrische Eigenschaften erzielt.

Gemäß einem zweiten Aspekt der Erfindung wird ein Verfahren zum Herstellen eines piezokeramischen Bauteils mit dem piezokeramischen Werkstoff mit folgenden Verfahrensschritten angegeben: a) Bereitstellen eines Grünkörpers mit einer piezokeramischen Ausgangszusammensetzung des piezokeramischen Werkstoffs und b) Wärmebehandeln des Grünkörpers, wobei aus der piezokeramischen Ausgangszusammensetzung der piezokeramische Werkstoff des Bauteils entsteht. Der Grünkörper ist ein Formkörper, der beispielsweise aus homogen vermischten, zusammen verpressten Oxiden der angegebenen Metalle besteht. Ebenso kann der Grünkörper ein organisches Additiv aufweisen, das mit den Oxiden der Metalle zu einem Schlicker verarbeitet ist. Das organische Additiv ist beispielsweise ein Binder oder ein Dispergator. Aus dem Schlicker wird in einem Formgebungsprozess ein Grünkörper erzeugt. Der Grünkörper ist beispielsweise eine Grünfolie, die durch den Formgebungsprozess. (Folienziehen) hergestellt wird. Der beim Formgebungsprozess hergestellte Grünkörper mit der piezokeramischen Ausgangszusammensetzung wird einer Wärmebehandlung unterzogen. Das Wärmebehandeln des Grünkörpers beinhaltet ein Kalzinieren und/oder ein Sintern. Es kommt zur Bildung und zum Verdichten des sich bildenden piezokeramischen Werkstoffs.

Zum Bereitstellen des Grünkörpers wird gemäß einer besonderen Ausgestaltung ein Mischen pulverförmiger, oxidischer Metallverbindungen der Metalle Alkalimetall Ap der Perowskit-Phase, Alkalimetall Aw der Wolframbronze-Phase und Niob zum Bilden der piezokeramischen Ausgangszusammensetzung durchgeführt. Gegebenenfalls werden die weiteren Metalle Tantal und Antimon als Oxide zugemischt. Dabei können neben Oxiden der Metalle, beispielsweise Antimonoxid (Sb₂O₅), Nioboxid (Nb₂O₅) und Tantaloxid (Ta₂O₅), auch Vorstufen der Oxide der Metalle, beispielsweise Carbonate (Li₂CO₃, K₂CO₃) oder Oxalate eingesetzt werden. Beide Arten von Metallverbindungen, also die Vorstufen der Oxide sowie die Oxide selbst, können als oxidische Metallverbindungen bezeichnet werden.

Die Pulver der oxidischen Metallverbindungen können nach bekannten Verfahren hergestellt werden, beispielsweise nach dem Sol-Gel-, dem Citrat-, dem Hydrothermal- oder dem Oxalatverfahren. Dabei können oxidische Metallverbindungen mit nur einer Art Metall hergestellt werden. Denkbar ist insbesondere auch, dass oxidische Metallverbindungen mit mehren Arten von Metallen eingesetzt werden (Mischoxide). Gemäß einer besonderen Ausgestaltung wird daher eine piezokeramische Ausgangszusammensetzung mit mindestens einer oxidischen Metallverbindung mit mindestens zwei der Metalle verwendet. Beispiele hierfür sind Lithiumniobat (LiNbO₃) oder Lithiumtantalat (LiTaO₃). Die oxidische Metallverbindung mit mindestens zwei der Metalle kann auch die Perowskit-Phase oder die Wolframbronze-Phase selbst sein. Zum Bereitstellen dieser Mischoxide kann auch auf die oben erwähnten Fällungreaktionen zurückgegriffen werden. Denkbar ist auch ein Mixed-Oxide-Verfahren. Dabei werden pulverförmige Oxide der Metalle miteinander vermischt und bei höheren Temperaturen kalziniert. Beim Kalzinieren entstehen die Mischoxide.

Die Aufarbeitung der Metalloxide mit der Überführung in den piezokeramischen Werkstoff kann auf verschiedenen Weisen erfolgen. Denkbar ist beispielsweise, dass zunächst die Pulver der oxidischen Metallverbindungen homogen vermischt werden. Es entsteht die piezokeramische Ausgangszusammensetzung in Form einer homogenen Mischung der Metalloxide. Anschließend wird die piezokeramische Ausgangszusammensetzung durch Wärmebehandeln, z.B. durch Kalzinieren, in den piezokeramischen Werkstoff überführt. Der piezokeramische Werkstoff wird zu feinem Piezokeramikpulver zermalen. Anschließend wird aus dem feinen Piezokeramikpulver im Formgebungsprozess ein keramischer Grünkörper mit einem organischen Binder und weiteren organischen Additiven hergestellt. Dieser keramische Grünkörper wird entbindert und gesintert. Dabei bildet sich das piezokeramische Bauteil mit dem piezokeramische Werkstoff.

Alternativ zum beschriebenen Vorgehen können die Pulver der oxidischen Metallverbindungen homogen vermischt und im Formgebungsprozess zum keramischen Grünkörper mit organischem Binder verarbeitet werden. Auch dieser Grünkörper weist die piezokeramische Ausgangszusammensetzung auf. Nachfolgendes Sintern führt zum piezokeramischen Bauteil mit dem piezokeramischen Werkstoff.

Gemäß einer besonderen Ausgestaltung wird ein piezokeramischer Bauteil mit mindestens einem Piezoelement hergestellt, das eine Elektrodenschicht mit Elektrodenmaterial, mindestens eine weitere Elektrodenschicht mit einem weiteren Elektrodenmaterial und mindestens eine zwischen den Elektrodenschichten angeordnete Piezokeramikschicht mit dem piezokeramischen Werkstoff aufweist. Ein einziges Piezoelement stellt die kleinste Einheit des piezokeramischen Bauteils dar. Zum Herstellen des Piezoelements wird beispielsweise eine keramische Grünfolie mit der piezokeramischen Ausgangszusammensetzung beidseitig mit den Elektrodenmaterialien bedruckt. Die Elektrodenmaterialien können dabei gleich oder unterschiedlich sein. Durch nachfolgendes Entbindern und Sintern resultiert das Piezoelement.

Gemäß einer besonderen Ausgestaltung wird ein Piezoelement verwendet, bei dem das Elektrodenmaterial und/oder das weitere Elektrodenmaterial mindestens ein aus der Gruppe Silber, Kupfer und Palladium ausgewähltes elementares Metall aufweisen. Der piezokeramische Werkstoff bzw. das Piezoelement wird insbesondere durch ein gemeinsames Sintern der piezokeramischen Ausgangszusammensetzung und der Elektrodenmaterials hergestellt (Cofiring). Das Elektrodenmaterial kann dabei aus den reinen Metallen bestehen, beispielsweise nur aus Silber oder nur aus Kupfer. Eine Legierung der genannten Metalle ist ebenfalls möglich, beispielsweise eine Legierung aus Silber und Palladium.

Das Sintern zum piezokeramischen Werkstoff kann sowohl in reduzierender oder oxidierender Sinteratmosphäre durchgeführt werden. In einer reduzierenden Sinteratmosphäre ist nahezu kein Sauerstoff vorhanden. Ein Sauerstoffpartialdruck beträgt weniger als 1.10⁻² mbar und vorzugsweise weniger als 1.10⁻³ mbar. Durch Sintern in einer reduzierenden Sinteratmosphäre ist kostengünstiges Kupfer als Elektrodenmaterial möglich. Prinzipiell kann mit Hilfe der piezokeramischen Ausgangszusammensetzung jedes beliebige piezokeramische Bauteil mit dem piezokeramischen Werkstoff hergestellt werden. Das piezokeramische Bauteil weist vornehmlich mindestens ein oben beschriebenes Piezoelement auf. Vorzugsweise wird das piezokeramische Bauteil mit dem Piezoelement aus der Gruppe piezokeramischer Biegewandler, piezokeramischer Vielschichtaktor, piezokeramischer Transformator, piezokeramischer Motor und piezokeramischer Ultraschallwandler ausgewählt. Das Piezoelement ist beispielsweise Bestandteil eines piezoelektrischen , Biegewandlers. Durch Übereinanderstapeln einer Vielzahl von einseitig oder beidseitig mit Elektrodenmaterial bedruckten Grünfolien, nachfolgendes Entbindern und Sintern entsteht ein monolithischer Stapel aus Piezoelementen. Bei geeigneter Dimensionierung und Form resultiert ein monolithischer piezokeramischer Vielschichtaktor. Dieser piezokeramische Vielschichtaktor wird vorzugsweise zur Ansteuerung eines Kraftstoffeinspritzventils einer Brennkraftmaschine eingesetzt. Durch die stapelförmige Anordnung der Piezoelemente ist auch, bei geeigneter Dimensionierung und Form, ein piezokeramischer Ultraschallwandler zugänglich. Der Ultraschallwandler wird beispielsweise in der Medizintechnik oder zur Materialprüfung eingesetzt.

Zusammenfassend ergeben sich mit der Erfindung folgende Vorteile:
- Es ist ein piezokeramischer Werkstoff zugänglich, der kein bzw. nahezu kein Blei aufweist.
- Der piezokeramische Werkstoff weist sehr gute piezoelektrische Eigenschaften auf. Dies betrifft beispielsweise eine relativ hohe Dehnung (d₃₃-Koeffizient) im Klein- und Großsignalbereich oder die Curietemperatur T_{c}, die bei über 200° C liegt.

Anhand eines Ausführungsbeispiels und der dazugehörigen

Figuren wird die Erfindung im Folgenden näher beschrieben. Die Figuren sind schematisch und stellen keine maßstabsgetreuen Abbildungen dar.
- Figur 1: zeigt ein keramisches Piezoelement mit einem piezokeramischen Werkstoff, das mit Hilfe einer geeigneten piezokeramischen Ausgangszusammensetzung hergestellt wurde, in einem seitlichen Querschnitt.
- Figur 2: zeigt ein piezokeramisches Bauteil mit einer Vielzahl von Piezoelementen in einem seitlichen Querschnitt.
- Figur 3: zeigt ein Röntgendiffraktogramm des piezokeramischen Werkstoffs.

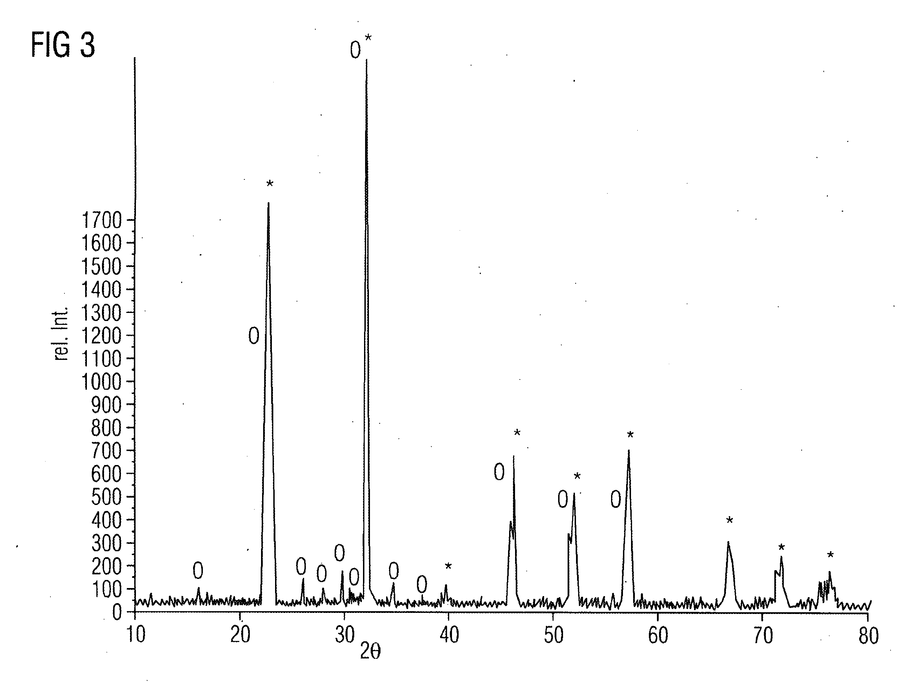

Der piezokeramische Werkstoff des Ausführungsbeispiels ist wie folgt erhältlich: Zunächst wird ein Grünkörper mit einer piezokeramischen Ausgangszusammensetzung bereitgestellt. Dazu wird zunächst ein Mischen pulverförmiger, oxidischer Metallverbindungen (Ausgangspulver) durchgeführt. Diese oxidischen Metallverbindungen sind im Einzelnen: Li₂CO₃, Na₂CO₃, K₂CO₃, Sb₂O₅, Nb₂O₅ und Ta₂O₅. Die Ausgangspulver werden mit entsprechenden Anteilen eingewogen und in Isopropanol 18h lang gemahlen. Die resultierende, feine Pulvermischung wird bei 750°C vier Stunden lang kalziniert. Die bei dieser Wärmebehandlung entstehende, piezokeramische Zusammensetzung wird wieder in Isopropanol für 18 h gemahlen und in einem Formgebungsprozess zu einem Grünkörper in Form eines Pulverpresslings mit etwa 12 mm Durchmesser verpresst. Dieser Pulverpressling wird bei einer Temperatur von 1050°C bis 1200° C eine Stunde lang zu einer Probe gesintert. Das Röntgendiffraktogramm (Figur 3) enthält Hinweise darauf, dass der piezokeramische Werkstoff zwei Phasen aufweist: Eine Perowskit-Phase mit der Summenformel (K_{0,4}Na_{0,6}) (Nb_{0,96}Sb_{0,04})O₃ (In Figur 3 mit * gekennzeichnet) und eine Wolframbronze-Phase mit der Summenformel Li₂K₃Ta₅O₁₅ (In Figur 3 mit O gekennzeichnet). Der Wolframbronze-Anteil der Wolframbronze-Phase am Feststoff des piezokeramischen Werkstoffs beträgt etwa 4 Vol.%. Der Perowskit-Anteil der Perowskit-Phase beträgt etwa 96 Vol.%.

Nachfolgend wird die Probe beidseitig mit Elektroden durch Aufdampfen von Silber versehen und bei etwa 100° C mit einem elektrischen Feld von etwa 2,5 kV/mm gepolt.

Die an der Probe gemessenen Eigenschaften des piezokeramischen Werkstoffs des Probenkörpers sind der Tabelle 1 zu entnehmen. Aufgelistet sind in der Tabelle 1 neben den d₃₃-Werten die mittlere Korngröße (mittlere Durchmesser Piezokeramik-Körner), der Kp-Wert (planarer Kopplungsfaktor), die relative Permittivität εᵣ (nach der Polung des piezokeramischen Werkstoffs) und die CurieTemperatur T_{c}.

**Tabelle 1:**

| | |
|---|---|
| | |
| Sintertemperatur [°C] | 1100 |
| εᵣ (nach der Polung) | 350 |
| Großsignal-d₃₃ bei 2 kV/mm [pm/V] | 400 |
| Großsignal-d₃₃ bei 1 kV/mm [pm/V] | 370 |
| Kp [%] | |
| Korngröße [µm] | |
| T_{Curie} [°C] | 285 |

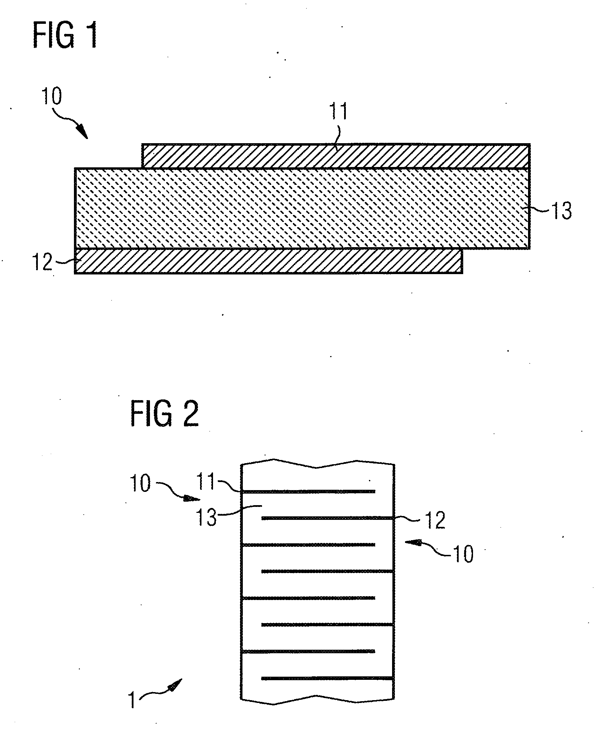

In Anlehnung an das beschriebene Verfahren zur Herstellung der Probe wird ein piezokeramisches Bauteil 1 mit dem piezokeramischen Werkstoff hergestellt. Das piezokeramische Bauteil 1 ist gemäß einer ersten Ausführungsform ein Piezoaktor 1 in monolithischer Vielschichtbauweise (Figur 2). Der Piezoaktor 1 besteht aus einer Vielzahl von übereinander zu einem Stapel angeordneten Piezoelementen 10 (Figur 1).

Jedes der Piezoelemente 10 weist eine Elektrodenschicht 11, eine weitere Elektrodenschicht 12 und eine zwischen den Elektrodenschichten 11 und 12 angeordnete Piezokeramikschicht 13 auf. Die im Stapel benachbarten Piezoelemente 10 weisen jeweils eine gemeinsame Elektrodenschicht auf. Die Elektrodenschichten 11 und 12 weisen ein Elektrodenmaterial aus einer Silber-Palladium-Legierung auf, bei der Palladium zu einem Anteil von 5 Gew.% enthalten ist. In einer alternativen Ausführungsform bestehen die Elektrodenschichten aus (annähernd) reinem Silber. Gemäß einer weiteren Alternative ist das Elektrodenmaterial Kupfer.

Zum Herstellen des Piezoaktors 1 werden Grünkörper in Form von Grünfolien mit der piezokeramischen Ausgangszusammensetzung bereitgestellt. Dazu wird die Pulvermischung mit der piezokeramischen Ausgangszusammensetzung mit einem organischen Binder und weiteren organischen Additiven vermischt. Aus dem auf diese Weise erhaltenen Schlicker werden die keramischen Grünfolien gegossen. Die Grünfolien werden getrocknet, mit einer Paste mit dem Elektrodenmaterial bedruckt, übereinander gestapelt, laminiert, entbindert und zum Piezoaktor 1 unter oxidierender Sinteratmosphäre (Silber oder Silber-Palladium-Legierung als Elektrodenmaterial) oder reduzierender Sinteratmosphäre (Kupfer als Elektrodenmaterial) gesintert.

Der resultierende monolithische piezokeramische Vielschichtaktor wird zum Betätigen eines Kraftstoffeinspritzventils einer Brennkraftmaschine eines Kraftfahrzeugs eingesetzt.

Weitere, nicht dargestellte Ausführungsformen wie piezokeramischer Biegewandler, piezokeramischer Transformator oder piezokeramischer Ultraschallwandler sind mit Hilfe der neuen piezokeramischen Zusammensetzung ebenfalls zugänglich.

## Patentansprüche

1. Piezokeramischer Werkstoff, aufweisend
- mindestens eine Perowskit-Phase mit der Summenformel Ap(Nb_{1-w-z}Ta_{w}Sb_{z})O₃, wobei Ap mindestens ein Alkalimetall der Perowskit-Phase ist und folgende Zusammenhänge gelten:
0 ≤ w ≤ 0,15 und
0 ≤ z ≤ 0,15,
und
- mindestens eine Wolframbronze-Phase mit der Summenformel Aw₅(Nb₁₋ᵥTaᵥ)₅O₁₅, wobei Aw mindestens ein Alkalimetall der Wolframbronze-Phase ist und folgender Zusammenhang gilt:
0 ≤ v ≤ 1.

2. Piezokeramischer Werkstoff nach Anspruch 1, wobei die Summenformel der Perowskit-Phase (LiₓK_{1-x-y}Na_{y}) (Nb_{1-w-z}Ta_{w}Sb_{z})O₃ lautet und folgende Zusammenhänge gelten:
0 ≤ x ≤ 0,15 und
0,25 ≤ y ≤ 0,75.

3. Piezokeramischer Werkstoff 1 oder 2, wobei die Summenformel der Wolframbronze-Phase Li₂(K₁₋ᵤNaᵤ)₃(Nb₁₋ᵥTaᵥ)₅O₁₅ lautet und folgender Zusammenhang gilt:
0 ≤ u ≤ 1.

4. Piezokeramischer Werkstoff nach Anspruch 3, wobei folgende Zusammenhänge gelten:
u = 0,
v = 1 und
x = 0.

5. Piezokeramischer Werkstoff nach einem der Ansprüche 1 bis 4, wobei ein Wolframbronze-Anteil der Wolframbronze-Phase am Feststoff des piezokeramischen Werkstoffs aus dem Bereich von einschließlich 0,01 vol.% bis einschließlich 25,0 Vol.% und insbesondere aus dem Bereich von einschließlich 0,05 Vol.% bis einschließlich 15,0 Vol.% ausgewählt ist.

6. Piezokeramischer Werkstoff nach einem der Ansprüche 1 bis 5, wobei ein molarer Bleianteil an der piezokeramischen Zusammensetzung unter 0,1 mol% und insbesondere unter 0,01 mol% beträgt.

7. Verfahren zum Herstellen eines piezokeramischen Bauteils (1) mit einem piezokeramischen Werkstoff nach einem der Ansprüche 1 bis 6 mit folgenden Verfahrensschritten:
a) Bereitstellen eines Grünkörpers mit einer piezokeramischen Ausgangszusammensetzung des piezokeramischen Werkstoffs und
b) Wärmebehandeln des Grünkörpers, wobei aus der piezokeramischen Ausgangszusammensetzung der piezokeramische Werkstoff des Bauteils (1) entsteht.

8. Verfahren nach Anspruch 7, wobei zum Bereitstellen des Grünkörpers ein Mischen pulverförmiger, oxidischer Metallverbindungen der Metalle Alkalimetall Ap der Perowskit-Phase, Alkalimetall Aw der Wolframbronze-Phase und Niob und gegebenenfalls der weiteren Metalle Tantal und Antimon zum Bilden der piezokeramischen Ausgangszusammensetzung durchgeführt wird.

9. Verfahren nach Anspruch 8, wobei eine piezokeramische Ausgangszusammensetzung mit mindestens einem Mischoxid mit mindestens zwei der Metalle verwendet wird.

10. Verfahren nach einem der Ansprüche 7 bis 9, wobei ein piezokeramisches Bauteil (1) mit mindestens einem Piezoelement (10) hergestellt wird, das eine Elektrodenschicht (11) mit Elektrodenmaterial, mindestens eine weitere Elektrodenschicht (12) mit einem weiteren Elektrodenmaterial und mindestens eine zwischen den Elektrodenschichten (11, 12) angeordnete Piezokeramikschicht (13) mit dem piezokeramischen Werkstoff aufweist.

11. Verfahren nach Anspruch 10, wobei ein Piezoelement (10) verwendet wird, bei dem das Elektrodenmaterial und/oder das weitere Elektrodenmaterial mindestens ein aus der Gruppe Silber, Kupfer und Palladium ausgewähltes elementares Metall aufweisen.

12. Verfahren nach einem der Ansprüche 7 bis 11, wobei das piezokeramische Bauteil (1) mit dem Piezoelement (10) aus der Gruppe piezokeramischer Biegewandler, piezokeramischer Vielschichtaktor, piezokeramischer Transformator, piezokeramischer Motor und piezokeramischer Ultraschallwandler ausgewählt wird.

13. Verwendung eines nach dem Verfahren nach Anspruch 12 hergestellten piezokeramischen Vielschichtaktors zur Ansteuerung eines Kraftstoffeinspritzventils einer Brennkraftmaschine.

## Claims

1. Piezoceramic material having
- at least one perovskite phase with the empirical formula Ap(Nb_{1-w-z}Ta_{w}Sb_{z})O₃, where Ap is at least one alkali metal of the perovskite phase and the following relationships apply:
0 ≤ w ≤ 0.15 and
0 ≤ z ≤ 0.15,
and
- at least one tungsten bronze phase with the empirical formula Aw₅(Nb₁₋ᵥTaᵥ)₅O₁₅, where Aw is at least one alkali metal of the tungsten bronze phase and the following relationship applies:
0 ≤ v ≤ 1.

2. Piezoceramic material according to claim 1, wherein the empirical formula of the perovskite phase is (LiₓK_{1-x-y}Na_{y}) (Nb_{1-w-z}Ta_{w}Sb_{z})O₃ and the following relationships apply:
0 ≤ x ≤ 0.15 and
0.25 ≤ y ≤ 0.75.

3. Piezoceramic material according to claim 1 or 2, wherein the empirical formula of the tungsten bronze phase is Li₂(K₁₋ᵤNaᵤ)₃(Nb₁₋ᵥTav)₅O₁₅ and the following relationship applies:
0 ≤ u ≤ 1.

4. Piezoceramic material according to claim 3, wherein the following relationships apply:
u = 0,
v = 1 and
x = 0.

5. Piezoceramic material according to one of claims 1 to 4, wherein a tungsten bronze fraction of the tungsten bronze phase in the solid matter of the piezoceramic material is selected from the range of 0.01 vol.% inclusive to 25.0 vol.% inclusive and in particular from the range of 0.05 vol.% inclusive to 15.0 vol.% inclusive.

6. Piezoceramic material according to one of claims 1 to 5, wherein a molar lead fraction in the piezoceramic composition is below 0.1 mol% and in particular below 0.01 mol%.

7. Method for producing a piezoceramic component (1) by means of a piezoceramic material according to one of claims 1 to 6, said method comprising the following steps:
a) providing a green compact having a piezoceramic precursor composition of the piezoceramic material and
b) thermally treating the green compact, with the piezoceramic material of the component (1) being produced from the piezoceramic precursor composition.

8. Method according to claim 7, wherein metal oxide compounds in powder form consisting of the metals alkali metal Ap of the perovskite phase, alkali metal Aw of the tungsten bronze phase and niobium, and where appropriate the further metals tantalum and antimony, are mixed to form the piezoceramic precursor composition in order to provide the green compact.

9. Method according to claim 8, wherein a piezoceramic precursor composition having at least one mixed oxide comprising at least two of the metals is used.

10. Method according to one of claims 7 to 9, wherein a piezoceramic component (1) is produced comprising at least one piezo element (10) which has an electrode layer (11) containing electrode material, at least one further electrode layer (12) containing a further electrode material and, arranged between the electrode layers (11, 12), at least one piezoceramic layer (13) containing the piezoceramic material.

11. Method according to claim 10, wherein a piezo element (10) is used in which the electrode material and/or the further electrode material have/has at least one elementary metal selected from the group comprising silver, copper and palladium.

12. Method according to one of claims 7 to 11, wherein the piezoceramic component (1) comprising the piezo element (10) is selected from the group comprising piezoceramic bending transducers, piezoceramic multilayer actuators, piezoceramic transformers, piezoceramic motors and piezoceramic ultrasonic transducers.

13. Use of a piezoceramic multilayer actuator produced by the method according to claim 12 for actuating a fuel injection valve of an internal combustion engine.

## Revendications

1. Matériau piézocéramique présentant
- au moins une phase de pérovskite répondant à la formule brute Ap(Nb_{1-w-z}Ta_{w}Sb_{z})O₃ dans laquelle Ap représente au moins un métal alcalin de la phase de pérovskite et les équations suivantes sont d'application :
0 ≤ w ≤ 0,15 et
0 ≤ z ≤ 0,15,
et
- au moins une phase de tungstène-bronze répondant à la formule brute Aw₅(Nb₁₋ᵥTaᵥ)₅O₁₅ dans laquelle Aw représente au moins un métal alcalin de la phase de tungstène-bronze et l'équation suivante est d'application :
0 ≤ v ≤ 1.

2. Matériau piézocéramique selon la revendication 1, dans lequel la phase de pérovskite répond à la formule brute (LiₓK_{1-x-y}Na_{y}) (Nb_{1-w-z}Ta_{w}Sb_{z})O₃ et les équations suivantes sont d'application:
0 ≤ x ≤ 0,15 et
0,25 ≤ y ≤ 0,75.

3. Matériau piézocéramique selon la revendication 1 ou 2, dans lequel la phase de tungstène-bronze répond à la formule brute Li₂(K₁₋ᵤNaᵤ)₃ (Nb₁₋ᵥTaᵥ)₅O₁₅ et l'équation suivante est d'application :
0 ≤ u ≤ 1.

4. Matériau piézocéramique selon la revendication 3, dans lequel les équations suivantes sont d'application :
u = 0
v = 1 et
x = 0.

5. Matériau piézocéramique selon l'une quelconque des revendications 1 à 4, dans lequel une fraction de tungstène-bronze de la phase de tungstène-bronze de la substance solide du matériau piézocéramique est choisie dans la plage de 0,01 % en volume inclus à 25,0 % en volume inclus et en particulier dans la plage de 0,05 % en volume inclus à 15,0 % en volume inclus.

6. Matériau piézocéramique selon l'une quelconque des revendications 1 à 5, dans lequel une fraction molaire de plomb de la composition piézocéramique est inférieure à 0,1 mol % et en particulier inférieure à 0,01 mol %.

7. Procédé pour la préparation d'un composant piézocéramique (1) comprenant un matériau piézocéramique selon l'une quelconque des revendications 1 à 6, comprenant les étapes opératoires suivantes :
a) procuration d'un corps vert possédant une composition piézocéramique de départ du matériau piézocéramique et
b) traitement thermique du corps vert, dans lequel on obtient le composant (1) à partir de la composition de départ piézocéramique du matériau piézocéramique.

8. Procédé selon la revendication 7, dans lequel, pour procurer le corps vert, on procède à un mélange de composés métalliques oxydés pulvérulents des métaux, à savoir le métal alcalin Ap de la phase de pérovskite, le métal alcalin Aw de la phase de tungstène-bronze et le niobium, et le cas échéant des métaux supplémentaires, à savoir le tantale et l'antimoine, pour obtenir la composition piézocéramique de départ.

9. Procédé selon la revendication 8, dans lequel on utilise une composition piézocéramique de départ comprenant au moins un oxyde mixte comprenant au moins deux des métaux.

10. Procédé selon l'une quelconque des revendications 7 à 9, dans lequel on prépare un composant piézocéramique (1) comprenant au moins un élément piézo-électrique (10) qui présente une couche (11) faisant office d'électrode comprenant une matière faisant office d'électrode, au moins une couche supplémentaire (12) faisant office d'électrode comprenant une matière supplémentaire faisant office d'électrode et au moins une couche piézocéramique (13) comprenant le matériau piézocéramique, disposée entre les couches (11, 12) faisant office d'électrodes.

11. Procédé selon la revendication 10, dans lequel on utilise un élément piézo-électrique (10) dans lequel la matière faisant office d'électrode et/ou la matière supplémentaire faisant office d'électrode présentent au moins un métal élémentaire choisi parmi le groupe comprenant l'argent, le cuivre et le palladium.

12. Procédé selon l'une quelconque des revendications 7 à 11, dans lequel le composant piézocéramique (1) comprenant l'élément piézo-électrique (10) est choisi parmi le groupe comprenant un convertisseur de flexion piézocéramique, un actionneur piézocéramique multicouche, un transformateur piézocéramique, un moteur piézocéramique et un transducteur ultrasonore piézocéramique.

13. Utilisation d'un actionneur piézocéramique multicouche fabriqué conformément au procédé selon la revendication 12, pour l'excitation d'un injecteur de carburant d'un moteur à combustion interne.
